# EUROPEAN PATENT SPECIFICATION

(11) **EP 4 471 190 B1**
(45) Date of publication and mention of the grant of the patent: **18.02.2026**
(21) Application number: 22923311.9
(22) Date of filing: 29.09.2022
(51) Int. Cl.: C30B 15/20, C30B 15/30, C30B 27/02, C30B 29/06

(54) **SINGLE CRYSTAL GROWTH DEVICE**
VORRICHTUNG ZUR EINKRISTALLZÜCHTUNG
DISPOSITIF DE CROISSANCE DE MONOCRISTAL

(30) Priority: 27.01.2022 CN 202210100195
(43) Date of publication of application: 04.12.2024
(73) Proprietor: Zhonghuan Advanced Semiconductor Technology Co., Ltd., Wuxi, Jiangsu 214203 (CN)
(72) Inventor: CHEN, Chun-hung, Xuzhou, Jiangsu 221004 (CN); WU, Wei, Xuzhou, Jiangsu 221004 (CN)
(74) Representative: Zacco GmbH
(86) International application number: PCT/CN2022/122625
(87) International publication number: WO 2023/142507

(56) References cited:
- CN-A- 1 309 728
- CN-A- 104 005 083
- CN-A- 112 725 884
- CN-A- 114 606 565
- CN-U- 214 992 008
- JP-A- 2019 043 828
- KR-B1- 101 028 933
- US-A1- 2001 054 376
- US-A1- 2003 116 729

## Description

### Technical Field

The invention relates to the technical field of crystal growth, and in particular to a single crystal growth device.

### Background

In a czochralski single crystal manufacturing method, a seed crystal is immersed in a raw material melt of silicon stored in a crucible in a chamber maintained in an inert gas environment under reduced pressure, and the immersed seed crystal is slowly pulled up, whereby single crystal silicon is grown below the seed crystal. In order to control the growing environment of the single crystal, an interval between a guide cylinder and liquid surface of the raw material melt of silicon in the crucible needs to be accurately controlled at a predetermined distance, but as the single crystal silicon rod grows continuously, the volume of the silicon melt in the crucible is reduced gradually, the liquid surface of the silicon melt drops continuously, and the interval between the guide cylinder and the liquid surface of the raw material melt of silicon in the crucible changes, which may affect the growth control of the crystal and the quality of the crystal. In the related art, the change of the liquid surface of the melt cannot be accurately judged, which directly affects the growth quality of the single crystal.

KR101028933B1 discloses a device for controlling the melt level in a single crystal growing apparatus.

### Summary

The invention provides a single crystal growth device, which may accurately observe a liquid level of a melt in a crucible, so as to ensure a growth quality of a single crystal.

A single crystal growth device according to an embodiment of the invention includes: a furnace body, inside which a furnace chamber is defined; a crucible, disposed in the furnace chamber in a liftable manner; a guide cylinder, located in the furnace chamber and above the crucible, a channel suitable for a crystal rod to pass through is disposed in a center of the guide cylinder, a first light transmission channel and a second light transmission channel which form a certain included angle and are communicated are formed in the guide cylinder, a light outlet hole communicating with the first light transmission channel and a light inlet hole communicating with the second light transmission channel are formed on the guide cylinder, and an area, opposite to the light inlet hole, of a junction position of an inner peripheral wall of the crucible and the melt in the crucible is a detection area; a reflection module, including a first reflection member, the first reflection member is disposed at a communication position of the first light transmission channel and the second light transmission channel, and the first reflection member is suitable for reflecting and turning a light entering the second light transmission channel into the first light transmission channel; and an image receiving module, and an image of the detection area is suitable for entering the image receiving module after being reflected by the reflection module.

For the single crystal growth device according to an embodiment of the invention, the first light transmission channel and the second light transmission channel which form the certain included angle and are communicated are formed in the guide cylinder, the light outlet hole communicating with the first light transmission channel and the light inlet hole communicating with the second light transmission channel are formed on the guide cylinder, and the area, opposite to the light inlet hole, of the junction position of the inner peripheral wall of the crucible and the melt in the crucible is the detection area, and the image of the detection area is suitable for entering the image receiving module after being reflected by the reflection module. According to reflection principle, when height of an image collected by the image receiving module is higher than a standard height, it indicates that the liquid level of the melt is lower than a standard position, when height of the image collected by the image receiving module is lower than the standard height, it indicates that the liquid level of the melt is higher than the standard position, thus a worker may timely know the change of the position height of the liquid surface of the melt in the crucible through the change of the image received by the image receiving module, which is convenient for the worker to raise or lower the crucible according to current position height of the liquid surface of the melt, so as to accurately control a vertical interval between the liquid surface of the melt and the guide cylinder in a set distance, which is beneficial for ensuring the growth quality of the single crystal.

In some embodiments of the invention, the first reflection member is a polished silicon sheet or a polished molybdenum sheet.

In some embodiments of the invention, in a direction from the first reflection member to the light outlet hole, the first light transmission channel extends obliquely upwards in a direction deviating from the crystal rod; and in a direction from the first reflection member to the light inlet hole, the second light transmission channel extends obliquely downwards in the direction deviating from the crystal rod.

In some embodiments of the invention, the light inlet hole and the light outlet hole are respectively located on two opposite sides along an up-down direction of the guide cylinder.

In some embodiments of the invention, the image receiving module and the detection area are located on a same side in a radial direction of the crystal rod, and the light outlet hole faces towards the image receiving module.

In some embodiments of the invention, the reflection module further includes: at least one second reflection member disposed above the first reflection member, and a reflection light of the first reflection member is suitable for entering the image receiving module after being reflected by the second reflection member.

In some embodiments of the invention, the image receiving module and the detection area are located on two opposite sides in a radial direction of the crystal rod, and the image of the detection area is suitable for entering the image receiving module by bypassing the crystal rod after being reflected by the first reflection member and the second reflection member.

In some embodiments of the invention, a plurality of second reflection members are provided, the plurality of second reflection members are distributed at intervals along a circumferential direction of the guide cylinder, the plurality of second reflection members are distributed at intervals along an up-down direction, and the reflection light of the first reflection member is suitable for entering the image receiving module by bypassing the crystal rod after being reflected by the plurality of second reflection members in sequence.

In some embodiments of the invention, two second reflection members are provided, which are defined as a primary reflection member and a secondary reflection member, the primary reflection member is located on a right upper side of the first reflection member, and the primary reflection member is suitable for obliquely upwards reflecting the reflection light of the first reflection member towards a right rear side; the secondary reflection member is located on an upper side of the primary reflection member, the secondary reflection member is located on the right rear side of the primary reflection member, and the secondary reflection member is suitable for obliquely upwards reflecting a reflection light of the primary reflection member towards a left rear side.

In some embodiments of the invention, an annular guide rail is disposed at an inner side of a top wall of the furnace body, the annular guide rail defines a sliding groove, a slider is disposed at a top of the image receiving module, the slider is embedded in the sliding groove, and the slider is suitable for sliding along an extending direction of the annular guide rail, so as to adjust a relative position of the image receiving module and the reflection module in a circumferential direction of the furnace body. The image receiving module includes: a first sub-receiving module, in which an accommodating cavity is defined, and an opening is formed at a bottom of the accommodating cavity; and a second sub-receiving module, slidably connected with the first sub-receiving module, and the second sub-receiving module is suitable for moving between a first position contained in the accommodating cavity and a second position extending out of the opening, so as to adjust a relative position of the second sub-receiving module and the reflection module in an axial direction of the furnace body.

Additional aspects and advantages of the invention will be set forth in part in the description which follows, and will be obvious in part from the description which follows, or may be learned by practice of the invention.

### Brief Description of the Drawings

Fig. 1 is a structure diagram of a sectional view of a single crystal growth device according to an embodiment of the invention.
Fig. 2 is a schematic diagram of light propagation when an image receiving module and a detection area of a single crystal growth device according to an embodiment of the invention are located on a same side of a crystal rod.
Fig. 3 is a partial structure diagram of a sectional view of a single crystal growth device according to an embodiment of the invention.
Fig. 4 is a schematic diagram of light propagation of change of a liquid level of a melt of a single crystal growth device according to an embodiment of the invention.
Fig. 5 is a schematic diagram of a front view of light propagation when an image receiving module and a detection area of a single crystal growth device according to an embodiment of the invention are located on two sides of a crystal rod.
Fig. 6 is a schematic diagram of a right view of light propagation when an image receiving module and a detection area of a single crystal growth device according to an embodiment of the invention are located on two sides of a crystal rod.

### Description of Reference Numerals:

100. Single crystal growth device;
1. Furnace body; 11. Furnace chamber; 2. Crucible; 21. Melt;
3. Guide cylinder;
31. First light transmission channel; 32. Second light transmission channel; 33. Light outlet hole; 34. Light inlet hole;
4. Crystal rod; 51. First reflection member; 52. Second reflection member; 52a. Primary reflection member; 52b. Secondary reflection member;
6. Image receiving module; and 7. Clamping device.

### Detailed Description of the Embodiments

The embodiments of the invention will be described in detail below, examples of which are illustrated in the drawings, in which like or similar reference numerals refer to the same or similar elements or elements having the same or similar function throughout. The embodiments described below by reference to the drawings are exemplary for explaining the invention and are not to be understood as limiting the invention.

The invention below provides a number of different embodiments or examples for implementing different structures of the invention. In order to simplify the invention of the application, the components and settings of a particular example are described below. Of course, they are only examples and are not intended to limit the invention. In addition, the invention may repeat reference numbers and/or letters in different examples. Such repetition is for the purpose of simplification and clarity, and does not in itself indicate the relationship between the various embodiments and/or settings discussed. In addition, the invention provides examples of various specific processes and materials, but those of ordinary skill in the art may be aware of the application of other processes and/or the use of other materials.

A single crystal growth device 100 according to an embodiment of the invention will be described below with reference to the accompanying drawings.

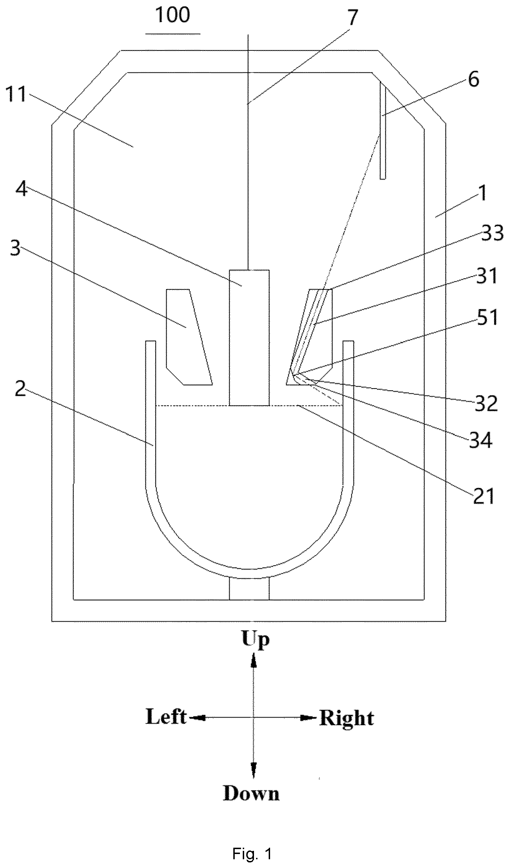

As shown in Fig. 1, a single crystal growth device 100 according to an embodiment of the invention includes a furnace body 1, a crucible 2, a guide cylinder 3, a reflection module and an image receiving module 6. A furnace chamber 11is defined in the furnace body 1, the crucible 2 is disposed in the furnace chamber 11 in a liftable manner, the guide cylinder 3 is located in the furnace chamber 11 and above the crucible 2, and a channel suitable for a crystal rod 4 to pass through is disposed in a center of the guide cylinder 3.

For example, a single crystal silicon rod may be produced through the single crystal growth device 100, first, a polycrystal is placed in the crucible 2 to be heated to form a melt 21 containing silicon, a seed crystal is impregnated in the melt 21, and by lifting and rotating the seed crystal, silicon atoms in the melt 21 crystallize at the bottom of the seed crystal. The diameter of the single crystal silicon rod may be controlled by controlling the lifting speed and/or rotation speed of the crystal rod 4. For example, the diameter of the single crystal silicon rod may be reduced by improving the lifting speed or rotation speed of the crystal rod 4, and the growth speed of single crystal silicon may be suppressed by increasing the temperature of the melt 21. On the contrary, the diameter of the single crystal silicon rod may be enlarged by reducing the lifting speed and/or rotation speed of the crystal rod 4, and the growth speed of single crystal silicon may be accelerated by decreasing the temperature of the melt 21.

In a specific example, the single crystal growth device 100 further includes a clamping device 7, the clamping device 7 is disposed in the furnace chamber 11 in a liftable and rotatable manner, the clamping device 7 is suitable for fixing the upper end of the crystal rod 4, and the clamping device 7 may drive the crystal rod 4 to lift, lower and rotate along an axial direction of the guide cylinder 3.

It is to be noted that in order to reduce the content of impurities such as oxygen in the single crystal, during the growth process of the single crystal, it is necessary to continuously supply inert gas such as argon to a halo area where the melt 21 and the crystal rod 4 contact, for example, the inert gas may be introduced downwards through an interval between the outer peripheral side of the crystal rod 4 and the guide cylinder 3, and the inert gas enters between the guide cylinder 3 and liquid surface of the melt 21 after flowing downwards, and flows towards the radial outer side of the guide cylinder 3, so as to maintain the inert gas environment under reduced pressure in the furnace chamber 11.

In order to guarantee the growth effect of the single crystal, the vertical interval between the guide cylinder 3 and the liquid surface of the melt 21 needs to be accurately controlled, meanwhile, in the growth process of the single crystal, the vertical interval between the guide cylinder 3 and the liquid surface of the melt 21 needs to be kept at a set value. However, with continuous crystallization of the silicon atoms in the melt 21 to produce the single crystal silicon rod, silicon content in the melt 21 is continuously reduced to lead to continuous lowering of height position of the liquid surface of the melt 21, further enlarging the vertical interval between the guide cylinder 3 and the liquid surface of the melt 21.

Therefore, in order to prevent change of the vertical interval between the guide cylinder 3 and the liquid surface of the melt 21 from influencing growth quality of the single crystal, an image of a detection area is suitable for entering the image receiving module 6 after being reflected by the reflection module, the detection area herein refers to a junction position of an inner peripheral wall of the crucible 2 and the melt 21 in the crucible 2, which may be reflected by the reflection module, so that a worker may timely know the change of position height of the liquid surface of the melt 21 in the crucible 2 through the change of the image received by the image receiving module 6, which is convenient for the worker to adjust the height of the crucible 2 according to current position height of the liquid surface of the melt 21, so as to accurately control the interval between the liquid surface of the melt 21 and the guide cylinder 3 in the set value, which is beneficial for ensuring the growth quality of the single crystal.

Specifically, when the liquid surface of the melt 21 is lower than a standard position, an incident angle of an incident light of the detection area on a first reflection member 51 is greater than a standard incident angle, according to the reflection principle, a reflection angle is equal to the incident angle, then the position height of an image formed on the image receiving module 6 finally is higher than a standard height, that is, when the height of the image collected by the image receiving module 6 is higher than the standard height, the liquid surface of the melt 21 is lower than the standard position. Similarly, when the liquid surface of the melt 21 is higher than the standard position, the incident angle of the incident light of the detection area on the first reflection member 51 is smaller than the standard incident angle, according to the reflection principle, the reflection angle is equal to the incident angle, then the position height of the image formed on the image receiving module 6 finally is lower than the standard height, that is, when the height of the image collected by the image receiving module 6 is lower than the standard height, the liquid surface of the melt 21 is higher than the standard position.

For example, when it is learned through the image receiving module 6 that the position height of the liquid surface of the melt 21 is higher than a set value, at the time, the interval between the liquid surface of the melt 21 and the guide cylinder 3 is smaller than the set value, then by controlling the crucible 2 to lower, namely, the crucible 2 to move in a direction away from the guide cylinder 3, the interval between the liquid surface of the melt 21 and the guide cylinder 3 is gradually enlarged till meeting the set distance. With continuous growth of the single crystal, the silicon content in the melt 21 is continuously reduced to lead to continuous lowering of position height of the liquid surface of the melt 21 in the crucible 2, therefore, when it is learned through the image receiving module 6 that the position height of the liquid surface of the melt 21 is lower than the set value, by controlling the crucible 2 to rise, namely, the crucible 2 to move in a direction close to the guide cylinder 3, the interval between the liquid surface of the melt 21 and the guide cylinder 3 is gradually shortened till meeting the set distance.

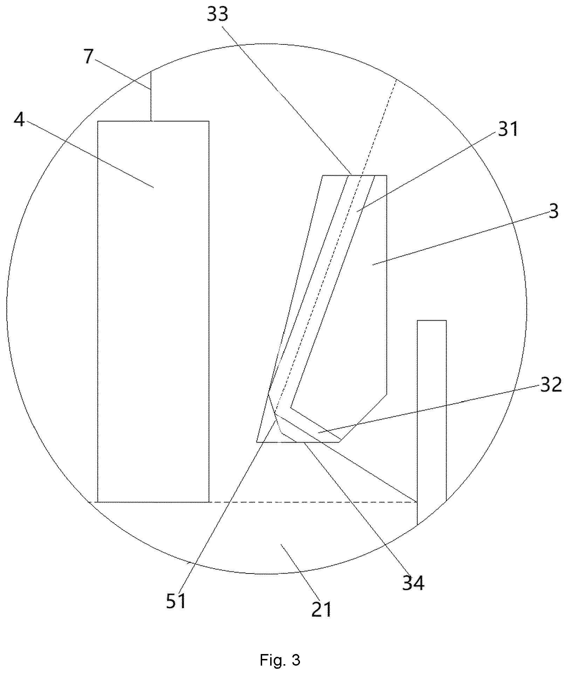

Specifically, as shown in Figs. 1-3, a first light transmission channel 31 and a second light transmission channel 32 which form a certain included angle and are communicated are formed in the guide cylinder 3, a light outlet hole 33 communicating with the first light transmission channel 31 and a light inlet hole 34 communicating with the second light transmission channel 32 are formed on the guide cylinder 3, an area, opposite to the light inlet hole 34, of the junction position of the inner peripheral wall of the crucible 2 and the melt 21 in the crucible 2 is the detection area, the reflection module includes a first reflection member 51, the first reflection member 51 is disposed at a communication position of the first light transmission channel 31 and the second light transmission channel 32, and the first reflection member 51 is suitable for reflecting and turning a light entering the second light transmission channel 32 into the first light transmission channel 31.

That is, an image of the detection area enters the second light transmission channel 32 through the light inlet hole 34, after reflection of the first reflection member 51, a light entering the first light transmission channel 31 is propagated towards the outside of the guide cylinder 3 through the light outlet hole 33, the first reflection member 51, the first light transmission channel 31 and the second light transmission channel 32 are disposed in the guide cylinder 3, therefore, the first reflection member 51 may fully utilize inside space of the guide cylinder 3, namely, mounting space of the first reflection member 51 is saved, meanwhile, light is seldom interfered by outside in the first light transmission channel 31 and the second light transmission channel 32, so that the image receiving module 6 may clearly and completely receive image information of the detection area, which is beneficial for improving accuracy of judging the change of position height of liquid surface of the melt 21. Meanwhile, the guide cylinder 3 may isolate part of heat, so that the first reflection member 51 located inside the guide cylinder 3 is seldom influenced by the high-temperature environment in the furnace chamber 11, which is beneficial for improving reliability of the first reflection member 51.

For the single crystal growth device 100 according to an embodiment of the invention, the first light transmission channel 31 and the second light transmission channel 32 which form the certain included angle and are communicated are formed in the guide cylinder 3, the light outlet hole 33 communicating with the first light transmission channel 31 and the light inlet hole 34 communicating with the second light transmission channel 32 are formed on the guide cylinder 3, the area, opposite to the light inlet hole 34, of the junction position of the inner peripheral wall of the crucible 2 and the melt 21 in the crucible 2 is the detection area, the image of the detection area is suitable for entering the image receiving module 6 after being reflected by the reflection module. According to the reflection principle, when the height of the image collected by the image receiving module 6 is higher than the standard height, it indicates that the liquid level of the melt 21 is lower than the standard position, when the height of the image collected by the image receiving module 6 is lower than the standard height, it indicates that the liquid level of the melt 21 is higher than the standard position, thus a worker may timely know the change of position height of liquid level of the melt 21 in the crucible 2 through the change of the image received by the image receiving module 6, which is convenient for the worker to raise or lower the crucible 2 according to the current position height of the liquid surface of the melt 21, so as to accurately control the vertical interval between the liquid surface of the melt 21 and the guide cylinder 3 in the set distance, which is beneficial for ensuring the growth quality of the single crystal.

In some embodiments of the invention, the first reflection member 51 is a polished silicon sheet or a polished silicon molybdenum sheet. The polished silicon sheet or polished molybdenum sheet has a mirror effect, with good reflection effect. In addition, the silicon sheet and the molybdenum sheet both have excellent high temperature resistance, so that the first reflection member 51 may adapt to the high temperature environment in the furnace chamber 11, so as to avoid the change of the reflection angle and the like caused by deformation of the first reflection member 51 under high temperature, thus promoting the reliability of the first reflection member 51. In the growth process of single crystal silicon, the polished silicon sheet may serve as the first reflection member 51, thus avoiding that the first reflection member 51 pollutes the growth of the single crystal silicon.

In some embodiments of the invention, in a direction from the first reflection member 51 to the light inlet hole 34, an inner diameter of the second light transmission channel 32 is enlarged That is, the inner diameter of the end, close to the first reflection member 51, of the second light transmission channel 32 is smaller than the inner diameter of the end, away from first reflection member 51, so that the first reflection member 51 may receive light in a wider range through the second light transmission channel 32, thereby expanding the area of the detection area. Therefore, the length of the detection area is prolonged therewith in an up-down direction, which is beneficial for improving the change range of position height of liquid surface of the melt 21 that may be received by image receiving module 6.

In some embodiments of the invention, in a direction from the first reflection member 51 to the light outlet hole 33, the first light transmission channel 31extends obliquely upwards in a direction deviating from the crystal rod 4, and in a direction from the first reflection member 51 to the light inlet hole 34, the second light transmission channel 32 extends obliquely downwards in the direction deviating from the crystal rod 4. That is, both the first light transmission channel 31 and the second light transmission channel 32 extend towards a radial outer side of the crystal rod 4 relative to the first reflection member 51, the detection area, the light inlet hole 34 and the light outlet hole 33 are all located on a side, away from the crystal rod 4, of the first reflection member 51, the detection area and the light inlet hole 34 are located obliquely below the first reflection member 51, the light outlet hole 33 is located obliquely above the first reflection member 51, so that the image of the detection area is incident on the first reflection member 51 towards an oblique upward direction close to the crystal rod 4, the reflected light of the first reflection member 51 is directed obliquely upward and away from the crystal rod 4, and is propagated outwards through the light outlet hole 33, that is, is reflected in a direction away from the crystal rod 4, therefore, it may better avoid interference of the crystal rod 4 or the clamping device 7 on the reflected light of the first reflection member 51, so that the image receiving module 6 may receive complete image information of the detection area, which is beneficial for improving the accuracy of judging the change of position height of the liquid surface of the melt 21.

In some embodiments of the invention, the light inlet hole 34 and the light outlet hole 33 are respectively located on two opposite sides along the up-down direction of the guide cylinder 3. Specifically, the light inlet hole 34 is disposed on the side, facing the liquid surface of the melt 21, of the guide cylinder 3, the light outlet hole 33 is disposed on the side, away from the liquid surface of the melt 21, of the guide cylinder 3, the upper end of the first light transmission channel 31 communicates with the light outlet hole 33, the lower end of the first light transmission channel 31 communicates with the upper end of the second light transmission channel 32, and the lower end of the second light transmission channel 32 communicates with the light inlet hole 34. Therefore, the reflected light of the first reflection member 51 may have a higher projection position. Therefore, the image receiving module 6 may be disposed at a higher position, for example, the image receiving module 6 may be disposed at the top of the furnace chamber 11, so that the image receiving module 6 is disposed away from the crucible 2, which may better avoid influence of the high temperature and the like on the image receiving module 6.

In a specific example, as shown in Fig. 1, the guide cylinder 3 is annular, a through hole for the crystal rod 4 to move up and down is formed in the middle of the guide cylinder 3, in a direction from bottom to top, the inner diameter of the through hole is enlarged gradually, the wall thickness of the guide cylinder 3 in the radial direction is reduced gradually after being enlarged gradually, the length of the first light transmission channel 31 is greater than the length of the second light transmission channel 32, the first reflection member 51 is disposed close to the bottom of the guide cylinder 3 and close to the crystal rod 4 relative to the light inlet hole 34 and the light outlet hole 33, the light inlet hole 34 is disposed on the lower side wall of the guide cylinder 3, and the light outlet hole 33 is disposed on the upper side wall of the guide cylinder 3. Therefore, the first light transmission channel 31 and the second light transmission channel 32 may better adapt to the structure of the guide cylinder 3, and the layout is reasonable.

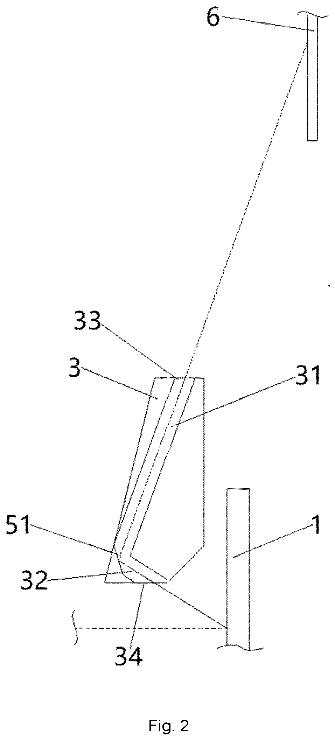

In some embodiments of the invention, as shown in Fig. 2, the image receiving module 6 and the detection area are located on a same side in the radial direction of the crystal rod 4, and the light outlet hole 33 faces towards the image receiving module 6. That is, the image receiving module 6 may directly receive the image of the detection area reflected by the first reflection member 51, that is, the image of the detection area received by the image receiving module 6 only needs to be reflected once, so that the reflection times of the image may be better reduced and the propagation path of the image may be better shortened, so as to reduce interference of the image in the propagation process, and the image receiving module 6 may receive the image information of the detection area clearly and completely, which is beneficial for improving the accuracy of judging the change of position height of the liquid surface of the melt 21.

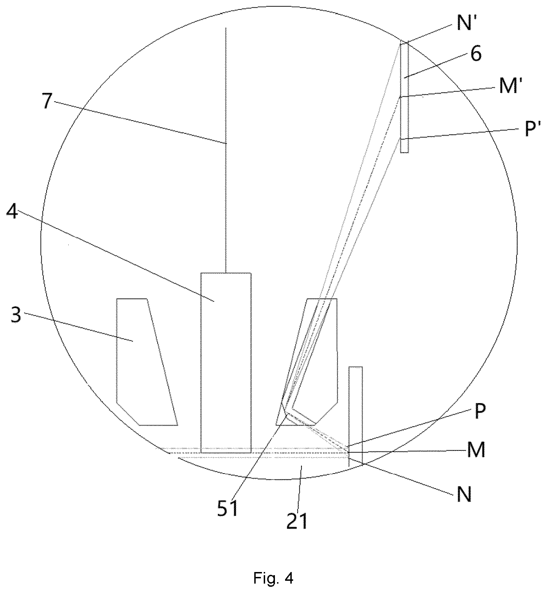

In a specific example, as shown in Fig. 4, the image receiving module 6 is disposed at the top of the furnace chamber 11 and extends along the up-down direction, specifically, before the growth of the single crystal, first, the vertical interval between the liquid surface of the melt 21 and the guide cylinder 3 is adjusted to the set value in a manner of lifting and lowering the crucible 2, at the time, the height of the liquid level of the melt 21 is an M position, after the setting of the interval, the image of the detection area received by the image receiving module 6 is marked as a set position (as the M' position shown in Fig. 4), according to the reflection principle of light, when the image received by the image receiving module 6 moves upwards relative to the M' position (as the N' position shown in Fig. 4), at the time, the height position of the liquid surface of the melt 21 in the crucible 2 falls (as the N position shown in Fig. 4), that is, the vertical interval between the liquid surface of the melt 21 and the guide cylinder 3 is enlarged, therefore, by controlling the crucible 2 to rise, the crucible 2 is enabled to move in a direction close to the guide cylinder 3, so that the interval between the liquid surface of the melt 21 and the guide cylinder 3 is gradually shortened till meeting the set distance.

When the image received by the image receiving module 6 moves downwards relative to the M' position (as the P' position shown in Fig. 4), at the time, the height position of the liquid surface of the melt 21 in the crucible 2 rises (as the P position shown in Fig. 4), that is, the vertical interval between the liquid surface of the melt 21 and the guide cylinder 3 is shortened, therefore, by controlling the crucible 2 to lower, namely, the crucible 2 moves in a direction away from the guide cylinder 3, the interval between the liquid surface of the melt 21 and the guide cylinder 3 is gradually enlarged till meeting the set distance.

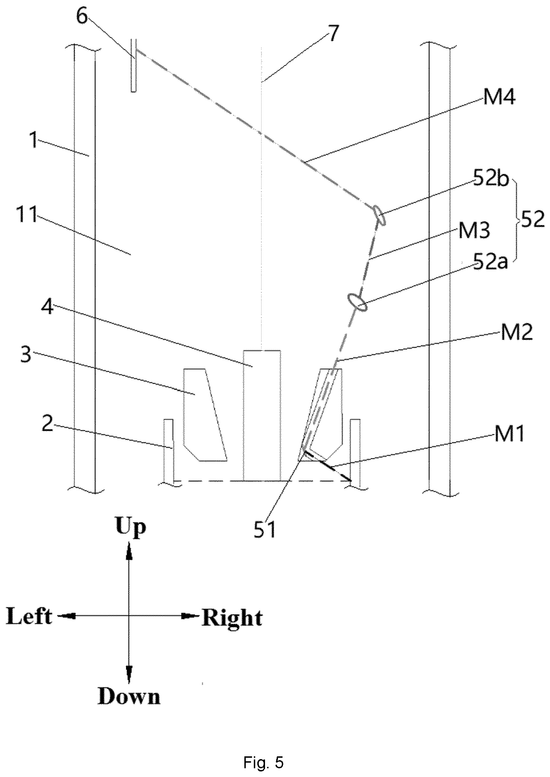

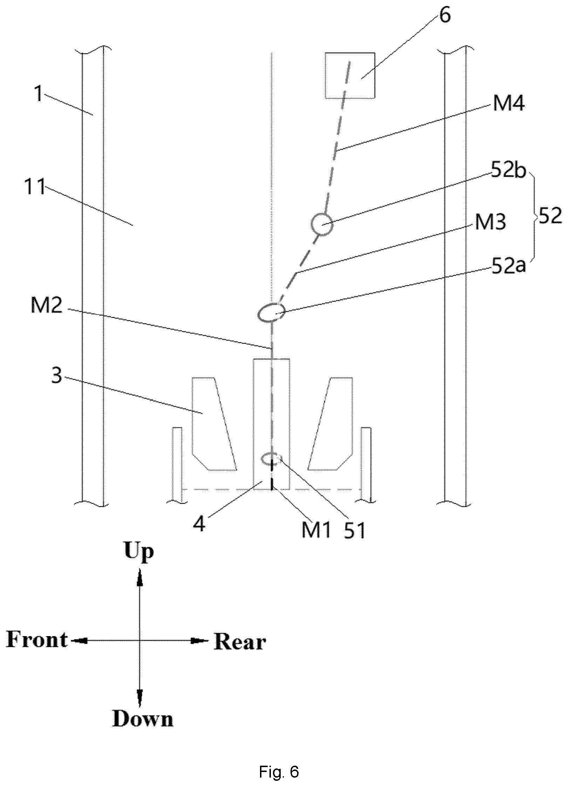

In some embodiments of the invention, as shown in Figs. 5 and 6, the reflection module further includes: at least one second reflection member 52, the second reflection member 52 is disposed above the first reflection member 51, and reflection light of the first reflection member 51 is suitable for entering the image receiving module 6 after being reflected by the second reflection member 52. It can be understood that reflection light of the first reflection member 51 may be re-reflected through the second reflection member 52, so that the propagation path of light may be re-adjusted flexibly.

Therefore, the reflection module may flexibly adjust the reflection direction of the second reflection member 52 according to the position of the image receiving module 6, so that the image receiving module 6 may clearly and completely receive image information of the detection area. For example, when the furnace body 1 is high and the image receiving module 6 is located on the top of the furnace chamber 11, referring to Fig. 5, the highest position of the reflection light of the first reflection member 51 may only reach the middle position of the furnace body 1, so that the image receiving module 6 cannot receive the reflection light of the first reflection member 51, therefore, by disposing the second reflection member 52 above the first reflection member 51, the second reflection member 52 may receive and further reflect the reflection light of the first reflection member 51, for example, by adjusting the orientation of the reflection surface of the second reflection member 52, the reflection angle of the second reflection member 52 may be accurately controlled, so that the image receiving module 6 may receive the reflection light of the second reflection member 52, namely, receive the image information of the detection area.

According to some embodiments of the invention, the image receiving module 6 and the detection area are located on two opposite sides in the radial direction of the crystal rod 4, and the image of the detection area is suitable for entering the image receiving module 6 by bypassing the crystal rod 4 after being reflected by the first reflection member 51 and the second reflection member 52. That is, the second reflection member 52 is suitable for reflecting the reflection light of the first reflection member 51 towards the side, away from the detection area, of the crystal rod 4, so that the image receiving module 6 may receive the image information of the detection area through the reflection module. In a specific example, as shown in Fig. 5, the detection area is located on the right side of the crystal rod 4, and the image receiving module 6 is located on the left side of the crystal rod 4.

According to some embodiments of the invention, the second reflection member 52 is located outside the guide cylinder 3 and above the guide cylinder 3. Therefore, the mounting difficulty of the second reflection member 52 may be better reduced, thus reducing the difficulty of later angle adjustment or maintenance of the second reflection member 52. Meanwhile, the distance of the first reflection member 51 and the second reflection member 52 in the radial direction of the guide cylinder 3 may be better prolonged, so that reflection light of the second reflection member 52 has a higher projection position, so as to adapt to image receiving modules 6 of different heights. Meanwhile, the distance of the second reflection member 52 and the liquid surface of the melt 21 may be better prolonged, so as to reduce influence of the high temperature of the melt 21 on the second reflection member 52. In addition, the second reflection member 52 is disposed on the outer side of the guide cylinder 3, so that the bad influence of position offset of the second reflection member 52 caused by the flow of the inert gas may be avoided, which is beneficial for improving completeness and clarity of the image received by the image receiving module 6.

Furthermore, a plurality of second reflection members 52 are provided, the plurality of second reflection members 52 are distributed at intervals along the axial direction of the guide cylinder 3, the plurality of second reflection members 52 are distributed at intervals along the up-down direction, and the reflection light of the first reflection member 51 is suitable for entering the image receiving module 6 by bypassing the crystal rod 4 after being reflected by the plurality of second reflection members 52 in sequence. It can be understood that the reflection light of the first reflection member 51 may be reflected for a plurality of times through the plurality of second reflection members 52, so that the propagation path of the light may be adjusted flexibly. Therefore, the plurality of times of reflection of the plurality of second reflection members 52 bypasses the crystal rod 4, so that the interference of the crystal rod 4 on the light may be better avoided, then the image receiving module 6 may clearly and completely receive the image of the detection area, which is beneficial for improving the accuracy of judging the change of position height of the liquid surface of the melt 21.

In some embodiments of the invention, two second reflection members 52 are provided, the two second reflection members 52 are defined as a primary reflection member 52a and a secondary reflection member 52b, the primary reflection member 52a is located on a right upper side of the first reflection member 51, and the primary reflection member 52a is suitable for obliquely upwards reflecting the reflection light of the first reflection member 51 towards a right rear side; the secondary reflection member 52b is located on an upper side of the primary reflection member 52a, the secondary reflection member 52b is located on the right rear side of the primary reflection member 52a, and the secondary reflection member 52b is suitable for obliquely upwards reflecting a reflection light of the primary reflection member 52a towards a left rear side.

In a specific example, as shown in Figs. 5 and 6, the reflection module includes one first reflection member 51 and two second reflection members 52 disposed at intervals in the up-down direction, first, the image of the detection area is transmitted to the first reflection member 51 along M1, the lower second reflection member 52 is located at the upper right of the first reflection member 51, and the lower second reflection member 52 is suitable for re-reflecting the reflection light of the first reflection member 51 (M2 as shown in Figs. 5 and 6) towards upward of the right rear side (M3 as shown in Figs. 5 and 6). The upper second reflection member 52 is located at the upper right of the lower second reflection member 52, the upper second reflection member 52 is suitable for re-reflecting the reflection light of the second reflection member 52 (M3 as shown in Figs. 5 and 6) towards upward of the left rear side (M4 as shown in Figs. 5 and 6), so that image information of the detection area is projected in the image receiving module 6 located at the upper left of the furnace chamber 11.

It is to be noted that the number of the second reflection member 52 may be flexibly set according to the height and other positions of the image receiving module 6, for example, the second reflection member 52 may be one, two, there, and the like, which is not limited herein.

According to some embodiments of the invention, the reflection surface of the first reflection member 51 faces obliquely upward. Therefore, the reflected light of the first reflection member 51 may be projected to a higher position. As shown in Fig. 1, in the vertical direction, relative to the top of the furnace chamber 11, the guide cylinder 3 has a shorter distance to the liquid surface of the melt 21, so that the first reflection member 51 is close to the liquid surface of the melt 21 in the vertical direction, therefore, by enabling the reflection surface of the first reflection member 51 to face obliquely upward, the first reflection member 51 may reflect the image of the detection area to a higher position, and the propagation path of the reflection light is longer. Furthermore, the reflection surface of the second reflection member 52 faces obliquely downwards, so that the second reflection member 52 may receive the reflection light of the first reflection member 51, so as to guarantee completeness of light propagation.

In some embodiments of the invention, an observation window (not shown in the figures) for observing the image information of the image receiving module 6 is disposed on the furnace body 1, and the observation window is disposed at the upper end of the furnace body 1. Therefore, through the observation window, the worker may intuitively know the change of the image information on the image receiving module 6, which is convenient for the worker to adjust the interval between the liquid surface of the melt 21 and the guide cylinder 3 in time according to the change of the image information, so as to ensure the growth quality of the single crystal.

In addition, as shown in Figs. 1-6, in a direction form bottom to top, the diameter of the through hole in the center of the guide cylinder 3 is gradually enlarged, the observation window is disposed at the upper end of the furnace body 1, so that the field of view of the observation window is wider, it can better prevent the guide cylinder 3 from blocking the halo area of the single crystal, so that the worker may observe the diameter of the single crystal through the observation window, thereby ensuring that the single crystal grows to meet the size requirement.

It is to be noted that directly observing the change of the image on the image receiving module 6 by disposing the observation window is only one of the ways to obtain the position height of the liquid surface of the melt 21, in a specific example, the image receiving module 6 is directly in communication connection with an upper computer, so that the received image information may be directly transmitted to the upper computer, the worker may observe through the upper computer, and the operation difficulty is low. In addition, the upper computer may, through comparison of the image information and the set image information, judge the current position height of the liquid surface of the melt 21, meanwhile, the upper computer may directly control the rising and lowering of the crucible 2 according to the change of the position height of liquid surface of the melt 21, which is beneficial for improving the automatic level of the single crystal growth device 100.

In some embodiments of the invention, an annular guide rail (not shown in the figures) is disposed at an inner side of a top wall of the furnace body 1, the annular guide rail defines a sliding groove, a slider (not shown in the figures) is disposed at a top of the image receiving module 6, the slider is embedded in the sliding groove, and the slider is suitable for sliding along an extending direction of the annular guide rail, so as to adjust a relative position of the image receiving module 6 and the reflection module in a circumferential direction of the furnace body 1. It can be understood that by moving the image receiving module 6 along the extending direction of the annular guide rail, the relative position of the image receiving module 6 and the reflection module in the circumferential direction of the furnace body 1 may be adjusted, so that the light reflected by the reflection module may be projected on the image receiving module 6, thus guaranteeing the accurate capturing of the reflection image. It is to be noted that after each time of charging of the single crystal growth device 100, position movement of parts possibly exists, in order to the guarantee accurate capturing for the reflection image, the relative position of the image receiving module 6 and the reflection module may be adjusted through the above operation.

In some embodiments of the invention, the image receiving module includes: a first sub-receiving module and a second sub-receiving module (not shown in the figures), an accommodating cavity is defined in the first sub-receiving module, an opening is formed at a bottom of the accommodating cavity, the second sub-receiving module is slidably connected with the first sub-receiving module, and the second sub-receiving module is suitable for moving between a first position contained in the accommodating cavity and a second position extending out of the opening, so as to adjust a relative position of the second sub-receiving module and the reflection module in an axial direction of the furnace body 1. It can be understood that by adjusting the movement between the first position and the second position of the second sub-receiving module, the relative position of the second sub-receiving module and the reflection module in the axial direction of the furnace body 1 may be adjusted, so that the light reflected by the reflection module may be projected on the image receiving module 6, thus guaranteeing the accurate capturing for the reflection image.

In summary, through the above design, the relative position of the image receiving module 6 and the reflection module may be more accurately adjusted in the axial and circumferential directions (two dimensions) of the furnace body 1, so as to further ensure the reliability of image capture.

In the invention, unless otherwise definitely specified and limited, terms "install", "mutually connect", "connect", "fix" and the like should be broadly understood. For example, the terms may refer to fixed connection and may also refer to detachable connection or integration. The terms may refer to direct mutual connection, may also refer to indirect connection through a medium and may refer to communication in two components or an interaction relationship of the two components. For those of ordinary skill in the art, specific meanings of these terms in the invention can be understood according to a specific condition.

In the descriptions of the specification, the descriptions made with reference to terms "an embodiment", "some embodiments", "example", "specific example", "some examples" or the like refer to that specific features, structures, materials or characteristics described in combination with the embodiment or the example are included in at least one embodiment or example of the invention. In the specification, these terms are not always schematically expressed for the same embodiment or example. Moreover, the specific described features, structures, materials or characteristics may be combined in a proper manner in any one or more embodiments or examples. In addition, those skilled in the art may integrate and combine different embodiments or examples described in the specification and features of different embodiments or examples without conflicts.

The embodiments of the invention have been shown or described, however, it can be understood by those of ordinary skill in the art that variations, modifications, replacements and transformations may be carried out on the embodiments without departing from the principle and purpose of the invention, and the scope of the invention shall be subject to the claims.

## Claims

1. A single crystal growth device, comprising
a furnace body (1), inside which a furnace chamber (11) is defined;
a crucible (2), disposed in the furnace chamber (11) in a liftable manner;
a guide cylinder (3), located in the furnace chamber (11) and above the crucible (2), a channel suitable for a crystal rod (4) to pass through is disposed in a center of the guide cylinder (3), a first light transmission channel (31) and a second light transmission channel (32) which form a certain included angle and are communicated are formed in the guide cylinder (1), a light outlet hole (33) communicating with the first light transmission channel (31) and a light inlet hole (34) communicating with the second light transmission channel (32) are formed on the guide cylinder (3), and an area, opposite to the light inlet hole (34), of a junction position of an inner peripheral wall of the crucible (2) and a melt (21) in the crucible (2) is a detection area;
a reflection module, comprising a first reflection member (51), the first reflection member (51) is disposed at a communication position of the first light transmission channel (31) and the second light transmission channel (32), and the first reflection member (51) is suitable for reflecting and turning a light entering the second light transmission channel (32) into the first light transmission channel (31);
an image receiving module (6), and an image of the detection area is suitable for entering the image receiving module (6) after being reflected by the reflection module.

2. The single crystal growth device according to claim 1, wherein the first reflection member (51) is a polished silicon sheet or a polished molybdenum sheet.

3. The single crystal growth device according to claim 1 or 2, wherein in a direction from the first reflection member (51) to the light outlet hole (33), the first light transmission channel (31) extends obliquely upwards in a direction deviating from the crystal rod (4); and in a direction from the first reflection member (51) to the light inlet hole (34), the second light transmission channel (32) extends obliquely downwards in the direction deviating from the crystal rod (4).

4. The single crystal growth device according to any one of claims 1-3, wherein the light inlet hole (34) and the light outlet hole (33) are respectively located on two opposite sides along an up-down direction of the guide cylinder (3).

5. The single crystal growth device according to any one of claims 1-4, wherein the image receiving module (6) and the detection area are located on a same side in a radial direction of the crystal rod (4), and the light outlet hole (33) faces towards the image receiving module (6).

6. The single crystal growth device according to any one of claims 1-5, wherein the reflection module further comprises: at least one second reflection member (52) disposed above the first reflection member (51), and a reflection light of the first reflection member (51) is suitable for entering the image receiving module (6) after being reflected by the second reflection member (52).

7. The single crystal growth device according to claim 6, wherein the image receiving module (6) and the detection area are located on two opposite sides in a radial direction of the crystal rod (4), and the image of the detection area is suitable for entering the image receiving module (6) by bypassing the crystal rod (4) after being reflected by the first reflection member (51) and the second reflection member (52).

8. The single crystal growth device according to claim 7, wherein a plurality of second reflection members (52) are provided, the plurality of second reflection members (52) are distributed at intervals along a circumferential direction of the guide cylinder (3), the plurality of second reflection members (52) are distributed at intervals along an up-down direction, and the reflection light of the first reflection member (51) is suitable for entering the image receiving module (6) by bypassing the crystal rod (4) after being reflected by the plurality of second reflection members (52) in sequence.

9. The single crystal growth device according to claim 8, wherein two second reflection members (52) are provided, which are defined as a primary reflection member (52a) and a secondary reflection member (52b), the primary reflection member (52a) is located on a right upper side of the first reflection member (51), and the primary reflection member (52a) is suitable for obliquely upwards reflecting the reflection light of the first reflection member (51) towards a right rear side;
the secondary reflection member (52b) is located on an upper side of the primary reflection member (52a), the secondary reflection member (52b) is located on the right rear side of the primary reflection member (52a), and the secondary reflection member (52b) is suitable for obliquely upwards reflecting a reflection light of the primary reflection member (52a) towards a left rear side.

10. The single crystal growth device according to any one of claims 1-9, wherein an annular guide rail is disposed at an inner side of a top wall of the furnace body (1), the annular guide rail defines a sliding groove, a slider is disposed at a top of the image receiving module (6), the slider is embedded in the sliding groove, and the slider is suitable for sliding along an extending direction of the annular guide rail, so as to adjust a relative position of the image receiving module (6) and the reflection module in a circumferential direction of the furnace body (1);
the image receiving module (6) comprises:
a first sub-receiving module, inside which an accommodating cavity is defined, and an opening is formed at a bottom of the accommodating cavity;
a second sub-receiving module, slidably connected with the first sub-receiving module, and the second sub-receiving module is suitable for moving between a first position contained in the accommodating cavity and a second position extending out of the opening, so as to adjust a relative position of the second sub-receiving module and the reflection module in an axial direction of the furnace body (1).

## Patentansprüche

1. Einkristall-Züchtungsvorrichtung, umfassend:
ein Ofengehäuse (1), in dem ein Ofenraum (11) definiert ist;
einen Tiegel (2), der in dem Ofenraum (11) auf anhebbare Weise angeordnet ist;
einen Führungszylinder (3), der sich in dem Ofenraum (11) und über dem Tiegel (2) befindet, wobei ein Kanal, der dafür geeignet ist, dass ihn ein Kristallstab (4) passiert, in einer Mitte des Führungszylinders (3) angeordnet ist, ein erster Lichtübertragungskanal (31) und ein zweiter Lichtübertragungskanal (32), die einen bestimmten eingeschlossenen Winkel bilden und miteinander verbunden sind,
in dem Führungszylinder (1) ausgebildet sind, ein Lichtaustrittsloch (33), das mit dem ersten Lichtübertragungskanal (31) in Verbindung steht, und ein Lichteintrittsloch (34), das mit dem zweiten Lichtübertragungskanal (32) in Verbindung steht, an dem Führungszylinder (3) ausgebildet sind und ein gegenüber der Lichteintrittsöffnung (34) befindlicher Bereich einer Verbindungsposition einer inneren umlaufenden Wand des Tiegels (2) und einer Schmelze (21) in dem Tiegel (2) ein Erfassungsbereich ist;
ein Reflexionsmodul, umfassend ein erstes Reflexionselement (51), wobei das erste Reflexionselement (51) an einer Kommunikationsposition des ersten Lichtübertragungskanals (31) und des zweiten Lichtübertragungskanals (32) angeordnet ist und das erste Reflexionselement (51) dazu geeignet ist, ein Licht, das in den zweiten Lichtübertragungskanal (32) eintritt, in den ersten Lichtübertragungskanal (31) zu reflektieren und umzulenken;
ein Bildempfangsmodul (6), wobei ein Bild des Erfassungsbereichs dazu geeignet ist, in das Bildempfangsmodul (6) einzutreten, nachdem es durch das Reflexionsmodul reflektiert wurde.

2. Einkristall-Züchtungsvorrichtung nach Anspruch 1, wobei das erste Reflexionselement (51) eine polierte Silikonplatte oder eine polierte Molybdänplatte ist.

3. Einkristall-Züchtungsvorrichtung nach Anspruch 1 oder 2, wobei sich der erste Lichtübertragungskanal (31) in einer Richtung von dem ersten Reflexionselement (51) zu dem Lichtaustrittsloch (33) schräg nach oben in einer von dem Kristallstab (4) abweichenden Richtung erstreckt; und sich der zweite Lichtübertragungskanal (32) in einer Richtung von dem ersten Reflexionselement (51) zu dem Lichteinlassloch (34) schräg nach unten in der von dem Kristallstab (4) abweichenden Richtung erstreckt.

4. Einkristall-Züchtungsvorrichtung nach einem der Ansprüche 1-3, wobei sich die Lichteinlassöffnung (34) und die Lichtauslassöffnung (33) jeweils auf zwei gegenüberliegenden Seiten entlang einer Auf-Ab-Richtung des Führungszylinders (3) befinden.

5. Einkristall-Züchtungsvorrichtung nach einem der Ansprüche 1-4, wobei sich das Bildempfangsmodul (6) und der Erfassungsbereich auf einer selben Seite in einer radialen Richtung des Kristallstabs (4) befinden und die Lichtauslassöffnung (33) dem Bildempfangsmodul (6) zugewandt ist.

6. Einkristall-Züchtungsvorrichtung nach einem der Ansprüche 1-5, wobei das Reflexionsmodul ferner Folgendes umfasst: mindestens ein zweites Reflexionselement (52), das über dem ersten Reflexionselement (51) angeordnet ist, und wobei ein Reflexionslicht des ersten Reflexionselements (51) dazu geeignet ist, in das Bildempfangsmodul (6) einzutreten, nachdem es durch das zweite Reflexionselement (52) reflektiert wurde.

7. Einkristall-Züchtungsvorrichtung nach Anspruch 6, wobei sich das Bildempfangsmodul (6) und der Erfassungsbereich auf zwei gegenüberliegenden Seiten in einer radialen Richtung des Kristallstabs (4) befinden und das Bild des Erfassungsbereichs dazu geeignet ist, in das Bildempfangsmodul (6) einzutreten, indem es den Kristallstab (4) umgeht, nachdem es durch das erste Reflexionselement (51) und das zweite Reflexionselement (52) reflektiert wurde.

8. Einkristall-Züchtungsvorrichtung nach Anspruch 7, wobei eine Vielzahl von zweiten Reflexionselementen (52) bereitgestellt ist, die Vielzahl von zweiten Reflexionselementen (52) in Abständen entlang einer Umfangsrichtung des Führungszylinders (3) verteilt ist, die Vielzahl von zweiten Reflexionselementen (52) in Abständen entlang einer Auf-Ab-Richtung verteilt ist und das Reflexionslicht des ersten Reflexionselements (51) dazu geeignet ist, in das Bildempfangsmodul (6) einzutreten, indem es den Kristallstab (4) umgeht, nachdem es durch die Vielzahl von zweiten Reflexionselementen (52) nacheinander reflektiert wurde.

9. Einkristall-Züchtungsvorrichtung nach Anspruch 8, wobei zwei zweite Reflexionselemente (52) bereitgestellt sind, die als ein primäres Reflexionselement (52a) und ein sekundäres Reflexionselement (52b) definiert sind, wobei sich das primäre Reflexionselement (52a) auf einer rechten Oberseite des ersten Reflexionselements (51) befindet und das primäre Reflexionselement (52a) dazu geeignet ist, das Reflexionslicht des ersten Reflexionselements (51) schräg nach oben in Richtung einer rechten Rückseite zu reflektieren;
wobei sich das sekundäre Reflexionselement (52b) auf einer Oberseite des primären Reflexionselements (52a) befindet, sich das sekundäre Reflexionselement (52b) auf der rechten Rückseite des primären Reflexionselements (52a) befindet und das sekundäre Reflexionselement (52b) dazu geeignet ist, ein Reflexionslicht des primären Reflexionselements (52a) schräg nach oben in Richtung einer linken Rückseite zu reflektieren.

10. Einkristall-Züchtungsvorrichtung nach einem der Ansprüche 1-9, wobei eine ringförmige Führungsschiene an einer Innenseite einer oberen Wand des Ofengehäuses (1) angeordnet ist, die ringförmige Führungsschiene eine Gleitnut definiert, ein Gleitstück an einer Oberseite des Bildempfangsmoduls (6) angeordnet ist, das Gleitstück in die Gleitnut eingebettet ist und das Gleitstück dazu geeignet ist, entlang einer Ausdehnungsrichtung der ringförmigen Führungsschiene zu gleiten, um dadurch eine relative Position des Bildempfangsmoduls (6) und des Reflexionsmoduls in einer Umfangsrichtung des Ofengehäuses (1) einzustellen;
das Bildempfangsmodul (6) Folgendes umfasst:
ein erstes Unterempfangsmodul, in dessen Innerem ein Aufnahmehohlraum definiert ist, wobei eine Öffnung an einem Boden des Aufnahmehohlraums ausgebildet ist;
ein zweites Unterempfangsmodul, das verschiebbar mit dem ersten Unterempfangsmodul verbunden ist, wobei das zweite Unterempfangsmodul dazu geeignet ist, sich zwischen einer ersten Position innerhalb des Aufnahmehohlraums und einer zweiten Position außerhalb der Öffnung zu bewegen, um dadurch eine relative Position des zweiten Unterempfangsmoduls und des Reflexionsmoduls in einer axialen Richtung des Ofengehäuses (1) einzustellen.

## Revendications

1. Dispositif de croissance de monocristal, comprenant :
un corps de four (1), à l'intérieur duquel est définie une chambre de four (11) ;
un creuset (2), disposé dans la chambre de four (11) d'une manière qui permet le levage ;
un cylindre de guidage (3), situé dans la chambre de four (11) et au-dessus du creuset (2), un canal approprié pour qu'une tige de cristal (4) puisse passer à travers est disposé dans un centre du cylindre de guidage (3), un premier canal de transmission de lumière (31) et un deuxième canal de transmission de lumière (32) qui forment un certain angle inclus et qui communiquent sont formés dans le cylindre de guidage (1), un trou de sortie de lumière (33) communiquant avec le premier canal de transmission de lumière (31) et un trou d'entrée de lumière (34) communiquant avec le deuxième canal de transmission de lumière (32) sont formés sur le cylindre de guidage (3), et une zone, opposée au trou d'entrée de lumière (34), d'une position de jonction d'une paroi périphérique intérieure du creuset (2) et d'une masse fondue (21) dans le creuset (2) est une zone de détection ;
un module de réflexion, comprenant un premier élément de réflexion (51), le premier élément de réflexion (51) est disposé à une position de communication du premier canal de transmission de lumière (31) et du deuxième canal de transmission de lumière (32), et le premier élément de réflexion (51) est approprié pour réfléchir et faire tourner une lumière entrant dans le deuxième canal de transmission de lumière (32) dans le premier canal de transmission de lumière (31) ;
un module de réception d'image (6), et une image de la zone de détection est appropriée pour entrer dans le module de réception d'image (6) après avoir été réfléchie par le module de réflexion.

2. Dispositif de croissance de monocristal selon la revendication 1, dans lequel le premier élément de réflexion (51) est une feuille de silicium polie ou une feuille de molybdène polie.

3. Dispositif de croissance de monocristal selon la revendication 1 ou 2, dans lequel dans une direction du premier élément de réflexion (51) vers le trou de sortie de lumière (33), le premier canal de transmission de lumière (31) s'étend obliquement vers le haut dans une direction déviant de la tige de cristal (4) ; et dans une direction du premier élément de réflexion (51) vers le trou d'entrée de lumière (34), le deuxième canal de transmission de lumière (32) s'étend obliquement vers le bas dans la direction déviant de la tige de cristal (4).

4. Dispositif de croissance de monocristal selon l'une quelconque des revendications 1 à 3, dans lequel le trou d'entrée de lumière (34) et le trou de sortie de lumière (33) sont respectivement situés sur deux côtés opposés le long d'une direction haut-bas du cylindre de guidage (3).

5. Dispositif de croissance de monocristal selon l'une quelconque des revendications 1 à 4, dans lequel le module de réception d'image (6) et la zone de détection sont situés sur un même côté dans une direction radiale de la tige de cristal (4), et le trou de sortie de lumière (33) fait face vers le module de réception d'image (6).

6. Dispositif de croissance de monocristal selon l'une quelconque des revendications 1 à 5, dans lequel le module de réflexion comprend en outre : au moins un deuxième élément de réflexion (52) disposé au-dessus du premier élément de réflexion (51), et une lumière de réflexion du premier élément de réflexion (51) est appropriée pour entrer dans le module de réception d'image (6) après avoir été réfléchie par le deuxième élément de réflexion (52).

7. Dispositif de croissance de monocristal selon la revendication 6, dans lequel le module de réception d'image (6) et la zone de détection sont situés sur deux côtés opposés dans une direction radiale de la tige de cristal (4), et l'image de la zone de détection est appropriée pour entrer dans le module de réception d'image (6) en contournant la tige de cristal (4) après avoir été réfléchie par le premier élément de réflexion (51) et le deuxième élément de réflexion (52).

8. Dispositif de croissance de monocristal selon la revendication 7, dans lequel une pluralité de deuxièmes éléments de réflexion (52) sont prévus, la pluralité de deuxièmes éléments de réflexion (52) sont distribués à intervalles le long d'une direction circonférentielle du cylindre de guidage (3), la pluralité de deuxièmes éléments de réflexion (52) sont distribués à intervalles le long d'une direction haut-bas, et la lumière de réflexion du premier élément de réflexion (51) est appropriée pour entrer dans le module de réception d'image (6) en contournant la tige de cristal (4) après avoir été réfléchie par la pluralité de deuxièmes éléments de réflexion (52) en séquence.

9. Dispositif de croissance de monocristal selon la revendication 8, dans lequel deux deuxièmes éléments de réflexion (52) sont prévus, qui sont définis comme un élément de réflexion primaire (52a) et un élément de réflexion secondaire (52b), l'élément de réflexion primaire (52a) est situé sur un côté supérieur droit du premier élément de réflexion (51), et l'élément de réflexion primaire (52a) est approprié pour réfléchir obliquement vers le haut la lumière de réflexion du premier élément de réflexion (51) vers un côté arrière droit ; l'élément de réflexion secondaire (52b) est situé sur un côté supérieur de l'élément de réflexion primaire (52a), l'élément de réflexion secondaire (52b) est situé sur le côté arrière droit de l'élément de réflexion primaire (52a), et l'élément de réflexion secondaire (52b) est approprié pour réfléchir obliquement vers le haut une lumière de réflexion de l'élément de réflexion primaire (52a) vers un côté arrière gauche.

10. Dispositif de croissance de monocristal selon l'une quelconque des revendications 1 à 9, dans lequel un rail de guidage annulaire est disposé sur un côté intérieur d'une paroi supérieure du corps de four (1), le rail de guidage annulaire définit une rainure de glissement, un curseur est disposé au sommet du module de réception d'image (6), le curseur est encastré dans la rainure de glissement, et le curseur est approprié pour glisser le long d'une direction d'extension du rail de guidage annulaire, de sorte à ajuster une position relative du module de réception d'image (6) et du module de réflexion dans une direction circonférentielle du corps de four (1) ;
le module de réception d'image (6) comprend :
un premier sous-module de réception, à l'intérieur duquel est définie une cavité de logement, et une ouverture est formée au fond de la cavité de logement ;
un deuxième sous-module de réception, connecté de manière coulissante avec le premier sous-module de réception, et le deuxième sous-module de réception est approprié pour se déplacer entre une première position contenue dans la cavité de logement et une deuxième position s'étendant hors de l'ouverture, de sorte à ajuster une position relative du deuxième sous-module de réception et du module de réflexion dans une direction axiale du corps de four (1).
